# EUROPÄISCHE PATENTSCHRIFT

(11) **EP 2 715 798 B1**
(45) Veröffentlichungstag und Bekanntmachung des Hinweises auf die Patenterteilung: **18.09.2019**
(21) Anmeldenummer: 12726390.3
(22) Anmeldetag: 30.05.2012
(51) Int. Cl.: H02S 40/32, H02S 40/34

(54) **MODULARE SOLARDOSE**
MODULAR SOLAR BOX
BOÎTIER DE RACCORDEMENT MODULAIRE, DESTINÉ À DES INSTALLATIONS SOLAIRES

(30) Priorität: 03.06.2011 CH 943112011
(43) Veröffentlichungstag der Anmeldung: 09.04.2014
(73) Patentinhaber: Belenos Clean Power Holding AG, 2502 Biel (CH)
(72) Erfinder: STANELLI, Daniel, CH-9630 Wattwil (CH); ZAHNER, Markus, CH-8645 Jona (CH); DA SILVA NETO, Henrique Paulo, CH-8602 Wangen (CH)
(74) Vertreter: ICB SA
(86) Internationale Anmeldenummer: PCT/EP2012/060179
(87) Internationale Veröffentlichungsnummer: WO 2012/163983

(56) Entgegenhaltungen:
- EP-A2- 2 242 113
- JP-A- 2002 330 556
- US-A1- 2010 275 991
- US-A1- 2011 083 733

## Beschreibung

Die vorliegende Erfindung liegt auf dem Gebiet der Solartechnik und betrifft eine Solardose zum Anschliessen einer Verkabelung an ein Solarpanel.

Photovoltaische Solaranlagen weisen in der Regel einen modularen Aufbau auf und bestehen aus einer Vielzahl von Solarzellen, welche über eine externe Verkabelung angeschlossen werden. Um eine höhere Spannung zu erzielen, werden die einzelnen Solarzellen zumindest gruppenweise in Serie geschaltet, indem der Pluspol einer ersten Solarzelle mit dem Minuspol einer weiteren Solarzelle verbunden wird. Ein Problem besteht dabei darin, dass bei einer partiellen Abdeckung einer Solarzelle, z.B. infolge von Schattenwurf von umstehenden Objekten oder durch Wolken, diese passiv wird und nur wenig oder gar nicht zur Stromproduktion beiträgt. Dies hat zur Folge, dass die abgedeckte Solarzelle bei einer Serieschaltung vom Strom der benachbarten Solarzelle durchflossen wird und dadurch Schaden nehmen oder zumindest eine Verringerung der Lebensdauer erfahren kann. Aus diesem Grund ist bekannt, dass Solarzellen mittels einer elektronischen Schaltung, die in der Regel Dioden als Schutzelemente aufweist, temporär überbrückt und damit während der Störung von der Stromproduktion abgekoppelt werden. Diese elektronischen Schaltungen werden häufig in Anschlussdosen untergebracht, die gleichzeitig zum Anschliessen der Verkabelung dienen.

WO2008/000101 derselben Anmelderin wurde 2008 publiziert und zeigt eine Anschlussdose mit einem Gehäuseunterteil und einem damit wirkverbindbaren Gehäuseoberteil, welches Haltemittel zur Aufnahme einer Platine aufweist. Das Gehäuseunterteil weist in der Regel einen Sockel auf, der zur Montage der Anschlussbox auf einer ebenen und/oder gekrümmten Oberfläche dient. Ein Vorteil besteht darin, dass insbesondere bei beschränkten Platzverhältnissen die Basisplatte zuerst befestigt werden kann. Anschliessend kann das Gehäuseunterteil, das zur Aufnahme des Gehäuseoberteils geeignet ist, mit der Basisplatte wirkverbunden werden.

WO2008/124951 derselben Anmelderin wurde 2008 publiziert und zeigt eine Anschlussdose mit einem Gehäuse und einem Anschlussschacht, welcher zum Anschliessen der Anschlussdose an elektrische Anschlüsse eines Solarpaneels dient. Das Gehäuse weist einen vorstehenden Montagesockel auf, der zur Befestigung der Anschlussdose an einer Oberfläche des Solarpaneels dient. Der Anschlusssockel ist so ausgestaltet, dass die Rückwand des Gehäuses in montiertem Zustand einen Abstand zum Solarpaneel aufweist, derart, dass eine konvektive Kühlung des Gehäuses resultiert.

WO2006/050890 der Fa. Solarwatt AG wurde 2006 publiziert und befasst sich mit einer Anschlusseinheit für photovoltaische Solarmodule. Die Anschlussdose weist einen Angussschacht mit einem fest angebauten Rahmen auf, der auf dem Solarpanel rückseitig grossflächig aufliegt und in den Kühlrippen als Modul eingeschoben werden kann. Ein Nachteil dieser Vorrichtung besteht darin, dass die Vorrichtung sehr kostenintensiv ist und trotz allem vergleichsweise eine grosse Bauhöhe aufweist. Montiert auf einem Solarpanel reduziert dies die Stapelbarkeit des Solarpanels und erhöht zudem die Beschädigungsgefahr bei Transport und Montage. Insbesondere die Kühlrippen stehen stark über die Rückseite vor und können die empfindliche Vorderseite eines Solarpanels einfach beschädigen.

US5951785 der Fa. Sanyo Electric Ltd. wurde 1997 erstmals publiziert und beschreibt eine Anordnung eines Inverters für ein Solarzellemodul. Mittels des Inverters kann der Gleichstrom des Solarzellenmoduls in einen Wechselstrom umgewandelt werden. Zur besseren Kühlung ist der Inverter in einem Abstand zur Rückwand eines Solarzellenmoduls angeordnet. Die Lagerung und vorteilhafte gegenseitige Positionierung der Gehäuse geht aus US'785 nicht hervor.

EP-A-2242113 offenbart eine Solardose mit einer Anschlussdose und einem Erweiterungsmodul.

Die aus dem Stand der Technik bekannten Solardosen für Solarpanel weisen den Nachteil auf, dass sie gross bauen und sich für eine flexible Bestückung nicht eignen. Insbesondere eine flexible Erweiterung der Funktionen ist bei den heute verfügbaren Anschlussdosen nicht vorgesehen. Ein weiterer Nachteil besteht darin, dass die aus dem Stand der Technik bekannten Solardosen nur sehr schlecht gewartet werden können. Z.B. besteht eines der Probleme darin, dass wenn eine Solardose ausfällt, dies in der Regel Auswirkungen auf mehrere benachbarte Solarpanels hat. Weiterhin besteht ein Problem darin, dass die bekannten Solardosen nur schlecht gegen Fremdeinwirkung geschützt sind.

Eine Aufgabe der Erfindung besteht darin, eine Solardose für ein Solarpanel zu zeigen, welche die dem Stand der Technik anhaftenden Probleme nicht aufweist.

Diese Aufgabe wird durch die in den Ansprüchen definierte Solardose gelöst.

Eine erfindungsgemässe Solardose weist ein mehrteiliges Gehäuse, respektive mehrere Einzelgehäuse auf, die über eine definierte Schnittstelle sowohl mechanisch als auch elektrisch miteinander wirkverbunden werden können. Die mehreren Einzelgehäuse sind mit Vorteil nach Funktion getrennt und so aufgebaut, dass sie zu einem späteren Zeitpunkt eine funktionale Erweiterung und/oder Umgestaltung der Solardose ermöglichen. Damit kann ein Solarpanel, z.B. wenn neue Gesetze in Kraft treten, flexibel den neuen Anforderungen angepasst werden.

Die normierte Schnittstelle hat neben elektrischen Kontakten auch mechanische Wirkverbindungsmittel, die so ausgelegt sind, dass sie auch über grössere Zeiträume (mehrere Jahre) beständig sind. Die Wirkverbindungsmittel sind mit Vorteil diametral seitlich und/oder unten und oben in einer Ebene oder senkrecht zu den elektrischen Kontakten angeordnet, so dass eine ausgewogene Kräfteverteilung resultiert. Die Wirkverbindungsmittel sind mit Vorteil selbstsperrend ausgestaltet, so dass die Verbindung zwischen zwei Gehäuseteilen nicht ohne die Verwendung eines Werkzeuges möglich ist.

Eine erfindungsgemässe Solardose weist neben einer Anschlussdose in der Regel mindestens ein weiteres Modul auf, welches mit der Anschlussdose über die normierte Schnittstelle wirkverbunden ist. Das mindestens eine Modul ist mit Vorteil so angeordnet, dass es gegenüber dem Solarpanel einen gewissen Spalt aufweist, um eine bessere Kühlung zu bewirken. Bei Bedarf können über die normierte Schnittstelle auch mehrere Module zusammengeschaltet werden. Die normierte Schnittstelle weist zu diesem Zweck die erforderliche Anzahl von mechanischen und elektrischen Kontakten auf.

In einer Ausführungsform weist die Solardose eine Anschlussdose mit einem Anschlussschacht zum elektrischen Wirkverbinden mit Anschlussbändern eines Solarpanels auf. Der Anschlussschacht wird vom Gehäuse der Anschlussdose begrenzt und ist mit einem Deckel verschliessbar. Bei Bedarf kann der Anschlussschacht so ausgestaltet sein, dass er ausgegossen werden kann. In die Anschlussbox kann bei Bedarf Elektronik integriert werden. Die Anschlussbox weist mit Vorteil eine Montagefläche (Sockel) auf, mittels der das Gehäuse der Anschlussbox auf einer Oberfläche eines Solarpanels durch Kleben befestigt werden kann. Die Montagefläche ist dabei mit Vorteil um den Anschlussschacht umlaufend ausgestaltet.

In einer bevorzugten Ausführungsform weist die Anschlussdose eine normierte Schnittstelle auf, die in einem rechten Winkel zum Anschlussschacht ausgestaltet ist. Die Mittelachse ist dabei mit Vorteil weniger als 3cm von der Montagefläche der Anschlussdose entfernt. Je nach Anwendungsgebiet können andere Bauhöhen gewählt werden.

Eine Ausführungsform der Erfindung betrifft eine Solardose mit einer Anschlussdose und mindestens einem Erweiterungsmodul, welches in zusammengesetztem Zustand mit der Anschlussdose über ein erstes und ein zweites Verbinderteil einer normierten Schnittstelle wirkverbunden sind. Die Anschlussdose weist einen Anschlussschacht auf, in welchen von mindestens einer Schachtwand her Kontakte hineinmünden, respektive hineinragen. Die Kontakte und die normierte Schnittstelle sind auf derselben Schachtseite angeordnet und werden mit Vorteil durch dieselben Teile gebildet, wobei die Kontakte in das erste Verbinderteil der normierten Schnittstelle direkt hineinragen können. Bei Bedarf sind die die Kontakte so angeordnet, dass sie gleichzeitig mit unterschiedlich ausgebildeten Anschlussbändern von unterschiedlichen Solarpaneln kompatibel sind. Dadurch besteht der Vorteil, dass keine unterschiedlichen Anschlussdosen notwendig sind.

Die Kontakte können einteilig ausgebildet sein, so dass möglichst wenig Verlust resultiert. Gute Resultate werden erzielt, indem die Kontakte durch Stanzen aus Blech hergestellt sind. Die Anschlussdose weist in der Regel einen Sockel auf, der zur Befestigung der Anschlussdose an einer Oberfläche eines Solarpanels dient. Der erste Verbinderteil ist gegenüber dem Sockel vertikal versetzt angeordnet. Der Sockel ist mit Vorteil so ausgestaltet, dass er den Anschlussschacht umgibt. Je nach Anwendungsgebiet kann der Anschlussschacht auch einseitig offen gestaltet werden. Die Anschlussdose weist mit Vorteil mechanische Wirkverbindungsmittel auf, mittels denen ein Erweiterungsmodul über zweite Wirkverbindungsmittel mechanisch mit einem Gehäuse der Anschlussdose wirkverbunden werden können. Die Solardose kann elektronische Bauelemente umfassen. Diese können folgende Funktionen übernehmen: Diebstahlschutz, Zentralabschaltung / Stromfreischaltung (Wartung / Reparatur), Notaus / Brandschutz (Schutz bei Feuerausbruch / Löschen), Überschlagserkennung (Brandverhinderung), MPPT (Maximum Power Point Tracking, Leistungsoptimierung), Microinverter (MPPT + DC/AC Wandlung), Datenerfassung (Seriennummer, Strom, Spannung, Temperatur). Die elektronischen Bauelemente sind entweder in die Anschlussdose und/oder mindestens in einem der Erweiterungsmodule integriert. In einer bevorzugten Ausführungsform sind die Anschlusskabel an einem Erweiterungsmodul ausgebildet. In diesem Fall können in dem Erweiterungsmodul elektronische Bauelemente integriert sein, welche ein Abkoppeln des Solarpanels in laufendem Betrieb ermöglichen. Weiterhin kann die Anschlussdose mechanische Wirk-verbindungsmittel aufweisen, die zum Anschliessen einer Halteschiene geeignet sind. In diesem Fall weist ein Erweiterungsmodul Führungsmittel auf, welche mit der Halteschiene wirkverbindbar sind. Alternativ kann das Erweiterungsmodul fest mit der Halteschiene wirkverbunden sein. Das Erweiterungsmodul ist mit Vorteil zur Oberfläche des Solarpanels beabstandet angeordnet, so dass zwischen dem Solarpanel und dem Zusatzmodul ein Luftspalt resultiert, welcher eine optimale Kühlung bewirkt.

Die normierten Schnittstellen sind mit Vorteil so ausgestaltet, dass sie durch Zusammenschieben der Gehäuseteile in einer Raumrichtung elektrisch und mechanisch wirkverbindbar sind. Die normierten Schnittstellen können auch so ausgebildet sein, dass sie durch eine Rotationsbewegung wirkverbindbar sind.

Anhand der in den nachfolgenden Figuren gezeigten Ausführungsbeispiele und der dazugehörigen Beschreibung wird die Erfindung näher erläutert. Es zeigen:
- Fig. 1: eine erste Ausführungsform einer Solardose in einer perspektivischen Darstellung von schräg vorne und oben;
- Fig. 2: die Solardose gemäss Figur 1 in einer perspektivischen Darstellung von schräg hinten und oben;
- Fig. 3: die Solardose gemäss Figur 1 in einer perspektivischen Darstellung von schräg vorne und hinten;
- Fig. 4: die Solardose gemäss Figur 1 in einer Seitenansicht;
- Fig. 5: eine zweite Ausführungsform einer Solardose in einer perspektivischen Darstellung von schräg vorne und oben;
- Fig. 6: die Solardose gemäss Figur 5 in einer perspektivischen Darstellung von schräg hinten und oben;
- Fig. 7: die Solardose gemäss Figur 5 in einer perspektivischen Darstellung von schräg vorne und hinten;
- Fig. 8: die Solardose gemäss Figur 5 in einer Seitenansicht;
- Fig. 9: die Solardose gemäss Figur 5 in einer erweiterten Konfiguration;
- Fig. 11: eine dritte Ausführungsform einer Solardose in einer perspektivischen Darstellung von schräg hinten und oben;
- Fig. 12: die Solardose gemäss Figur 11 von schräg vorne und unten;
- Fig. 13: eine Variante der Solardose gemäss Figur 11 von schräg hinten und oben;
- Fig. 14: die Solardose gemäss Figur 11 von schräg unten vorne und oben in zusammengesetzten Zustand;
- Fig. 15: die Solardose gemäss Figur 11 von vorne und unten;
- Fig. 16: eine vierte Ausführungsform einer Solardose in einer perspektivischen Darstellung von schräg vorne und oben;
- Fig. 17: Detail D gemäss Figur 16.

In den nachfolgenden Figuren werden für sich entsprechende Teile/Bereiche identische Bezugszeichen verwendet.

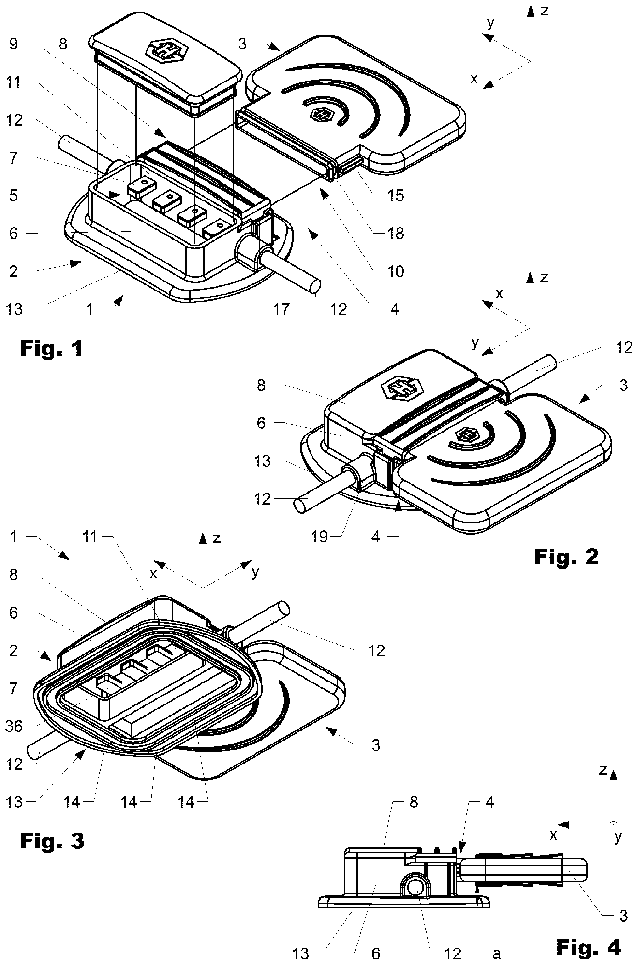

**Figur 1** zeigt eine erste Ausführungsform einer erfindungsgemässen Solardose 1 in einer perspektivischen Darstellung von schräg vorne und oben. **Figur 2** zeigt die Solardose 1 in einer perspektivischen Darstellung von schräg hinten und oben. **Figur 3** zeigt die Solardose 1 in einer perspektivischen Darstellung von schräg vorne und unten und **Figur 4** zeigt die Solardose 1 in einer Seitenansicht.

Die dargestellte Solardose 1 besteht aus einer Anschlussdose 2 und einem Erweiterungsmodul 3, die über eine normierte Schnittstelle 4 mit der Anschlussdose 2 von der Seite her (x-Richtung) wirkverbindbar ist. Die normierte Schnittstelle 4 dient zur Übertragung von Strom und falls erforderlich Daten. Gleichzeitig bewirkt sie auch eine mechanische Halterung des Erweiterungsmoduls 3 gegenüber der Anschlussdose 2. Während dem die Anschlussdose 2 primär zur Befestigung der Solardose 1 an einem Solarpanel (nicht näher dargestellt) dient, dient das Erweiterungsmodul 3 zur Aufnahme von elektronischen Bauelementen, z.B. Dioden, usw., welche zur Steuerung der Funktion eines angeschlossenen Solarpanels oder für die Verarbeitung von Daten relevant sind.

In **Figur 1** ist die Solardose 1 in zerlegtem Zustand dargestellt. Die einzelnen Gehäuse sind voneinander getrennt dargestellt. Die Anschlussdose 2 weist einen Anschlussschacht 5 auf, der durch ein Gehäuse 6 gebildet wird. In den Anschlussschacht 5 ragen von der Seite her Kontakte 7 hinein, welche zum Anschliessen an korrespondierende Kontaktbänder des Solarpanels dienen (beide nicht näher dargestellt). Die Kontakte 7 sind auf einer dem Erweiterungsmodul 3 zugewendeten Schachtseite ausgebildet. Der Anschlussschacht 5 kann durch einen Deckel 8 verschlossen werden. Die normierte Schnittstelle 4 weist (auf das Gehäuse bezogene) einen anschlussdosenseitig gelegenen ersten Verbinderteil 9 und einen erweiterungsmodulseitig gelegenen zweiten Verbinderteil 10 auf. Die Kontakte 7 ragen in der gezeigten Ausführungsform direkt in den ersten Verbinderteil 9 hinein und sind mit Vorteil einteilig, z.B. aus Blech ausgebildet. Schachtseitig ragen sie aus einer Schachtwand 11 hervor und sind mit Vorteil so angeordnet, dass sie auf die Anschlüsse eines oder mehrer Solarpanel kompatibel sind. Das Gehäuse 6 wird mit Vorteil durch Spritzgiessen aus Kunststoff hergestellt. Die Kontakte 7 können als separate Teile in die Spritzgiessform eingelegt und umspritzt werden. Alternativ können sie in ein vorgängig hergestelltes Gehäuse eingepresst werden. In einer weiteren Ausführungsform weist das Gehäuse 6 einen mehrteiligen Aufbau auf, so dass die Kontakte 7 in ein erstes Gehäuseteil eingelegt und dieses dann mit einem zweiten Gehäuseteil verschlossen wird.

In der in den **Figuren 1** bis **4** gezeigten Ausführungsform weist die Anschlussdose Anschlusskabel 12 auf, die zum Anschliessen der Solardose 1 dienen. Die Anschlusskabel 12 sind seitlich an der Anschlussdose 2 ausgebildet. Die Anschlusskabel 12 stehen mit den Kontakten 7 und dem Erweiterungsmodul 3 in Wirkverbindung.

Bei Bedarf können z.B. für die grundlegende Regelung der Funktionsweise relevante elektronische Bauelemente in das Gehäuse 6 der Anschlussdose 2 integriert sein. Z.B. besteht die Möglichkeit, Dioden (nicht näher dargestellt), welche zum Überbrücken eines Solarpanels bei Abschattung dienen und/oder andere Steuerungselektronik in die Anschlussdose 2 zu integrieren. Diese Elemente werden mit Vorteil zwischen dem Anschlussschacht 5 und dem ersten Verbinderteil 9 angeordnet.

Wie in **Figur 3** zu erkennen ist, weist das Gehäuse 6 einen Sockel 13 auf, welcher den Anschlussschacht 6 umlaufend umgibt. Der Sockel 13 dient zum Ankleben der Anschlussdose 2 an eine Oberfläche eines Solarpanels. Er weist hier mehrere nach unten vorstehende Stege 14 auf, welche eine bessere Verankerung des Klebstoffes bewirken.

Die Kontakte 7 sind in der gezeigten Ausführungsform horizontal (x-y-Ebene) liegend auf von der Schachtwand 11 vorstehenden Trägerelementen 36 angeordnet, welche die Kontakte 7 insbesondere beim Anschliessen der Kontaktbänder eines Solarpanels stützen. Beim Kontaktieren des Solarpanels wird dieses dadurch gleichzeitig gegen hohe Temperaturen isoliert. Bei Bedarf können die Kontakte auch vertikal stehend oder in einer schrägen Ebene verlaufend angeordnet sein, so dass sie von der Seite her oder in einem gewissen Winkel kontaktiert werden können.

Wie in der in **Figur 4** gezeigten Seitenansicht (y-Richtung) zu erkennen ist, ist die normierte Schnittstelle 4 im Bereich des oberen Endes des Schachtes 5 angeordnet. Das Erweiterungsmodul 3 weist in wirkverbundenem Zustand einen Abstand a auf, so dass zwischen dem Solarpanel und dem Erweiterungsmodul ein Luftspalt resultiert. Der Abstand a bewirkt eine verbesserte Kühlung. Falls erforderlich kann das Erweiterungsmodul 3 Kühlrippen aufweisen. Bei Bedarf kann das Erweiterungsmodul 3 zusätzlich direkt oder indirekt auf dem Solarpanel abgestützt oder fixiert sein. Die gezeigte Solardose 1 weist einen einfachen und kostengünstig herzustellenden Aufbau mit einem vergleichsweise guten Kühlverhalten auf. Die Kräfte für die Halterung des Erweiterungsmoduls 3 werden durch die normierte Schnittstelle 4 übertragen. Die normierte Schnittstelle 4 weist zu diesem Zweck mechanische Wirkverbindungsmittel 15, 16 auf, welche zum Fixieren des Erweiterungsmoduls 3 gegenüber der Anschlussdose 2 dienen. Wie in **Figur** 1 zu erkennen ist, bestehen die Wirkverbindungsmittel 15, 16 in der gezeigten Ausführungsform aus beidseits des zweiten Verbinderteils 10 angeordneten Kämmen 15, welche in korrespondierend ausgebildete Nuten 16 des zweiten Verbinderteils 9 eingreifen, respektive in diese eingeschnappt werden können und eine stabile, dauerhafte mechanische Verbindung bewirken. In der gezeigten Ausführungsform können die mechanische Verbindung gelöst werden, indem ein Werkzeug, z.B. ein Schraubenzieher, in seitlich am Gehäuse 6 ausgebildete Entriegelungsöffnungen 17 eingeführt wird. Dies führt dazu, dass im Innern angeordnete Schnappelemente (nicht zu erkennen) in eine Entriegelungsposition gebracht werden und damit das Erweiterungsmodul freigegeben wird. Durch eine seitliche Anordnung der Wirkverbindungsmittel wird eine gute Kräfteverteilung bewirkt. Der zweite Verbinderteil weist zudem eine umlaufende Nut 18 zur Aufnahme einer Dichtung auf (nicht dargestellt).

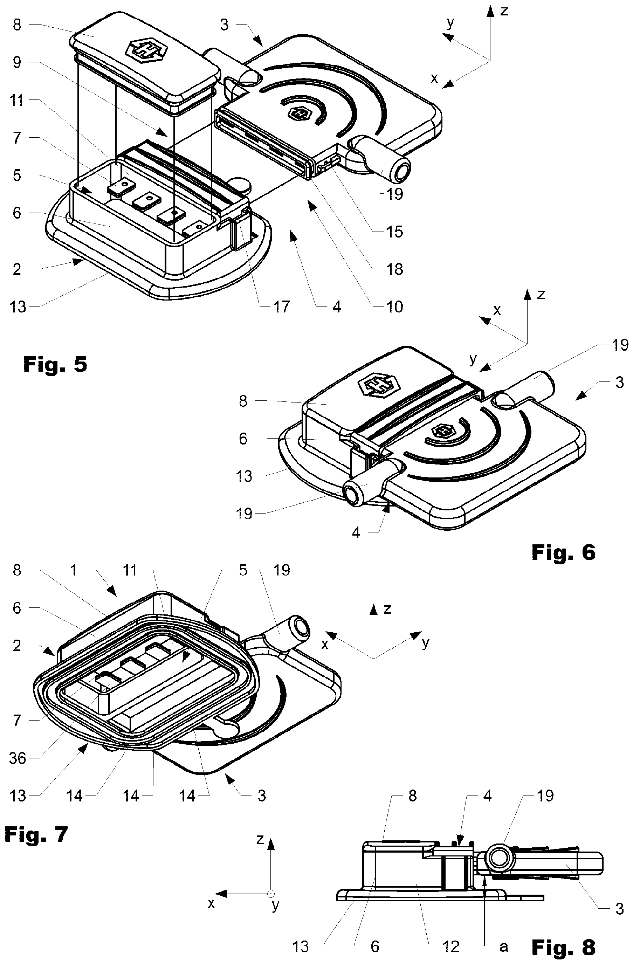

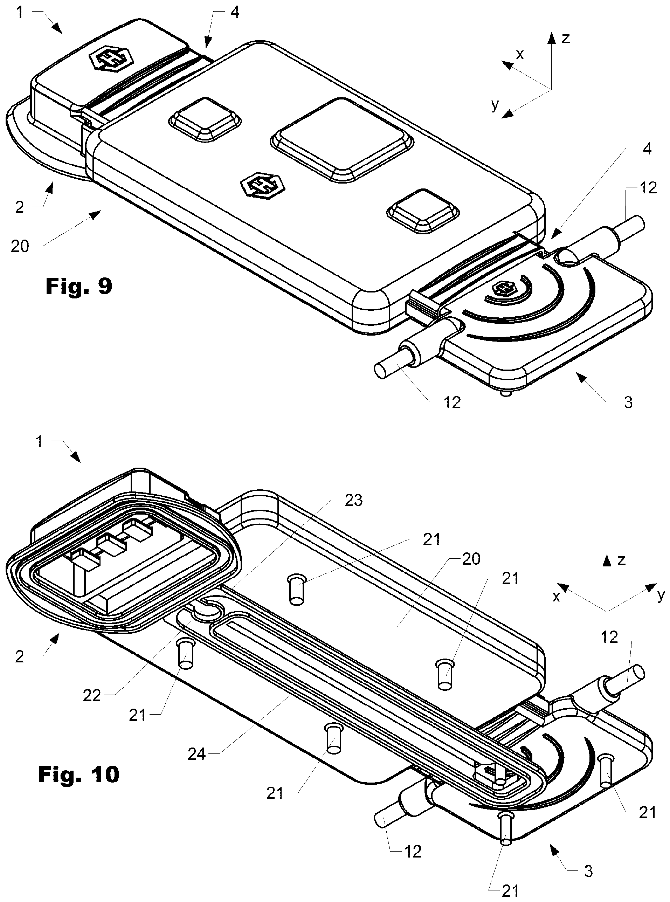

In den **Figuren 5** bis **8** ist eine weitere Ausführungsform einer erfindungsgemässen Solardose 1 gezeigt. Der Aufbau und die Funktionsweise entsprechen im Wesentlich der in den Figuren 1 bis 4 gezeigten Ausführungsform, so dass für die allgemeine Beschreibung auf diese Figuren verwiesen und hier nur noch auf die Unterschiede eingegangen wird. Bei der zweiten Ausführungsform sind die Anschlusskabel (hier schematisch anhand von Kabelöffnungen 19 gezeigt) am Erweiterungsmodul 3 und nicht an der Anschlussdose 2 angebracht. Das Erweiterungsmodul 3 und die Kabel können so bei Bedarf vorkonfektioniert und dann bei der Montage nur noch mit der auf dem Solarpanel befestigten Anschlussdose 2 wirkverbunden werden. Ein weiterer Vorteil besteht darin, dass das Solarpanel durch Ausstecken des Erweiterungsmoduls 3 getrennt werden kann, ohne dass weitere in Serie geschaltete Solarpanels unterbrochen werden. Dies ist insbesondere im Fall eines Defektes eines Solarpanels vorteilhaft, da es einen einfachen Austausch garantiert. Das Erweiterungsmodul, respektive die Anschlussdose 2 weisen Mittel auf, welche die Bildung von Lichtbogen vermeiden. Ein weiterer Vorteil besteht darin, dass die Solardose 1 - wie in den Figuren 9 und 10 gezeigt - flexibel erweitert werden kann.

In den **Figuren 9** und **10** ist die Solardose 1 gemäss den **Figuren 5** und **8** in einer erweiterten Konfiguration gezeigt. Betreffend die allgemeine Funktionsweise wird auf die Beschreibung der vorangehenden Figuren verwiesen. In **Figur 9** ist die Solardose von schräg oben und hinten und in **Figur 10** von schräg unten und vorne gezeigt. Zwischen der Anschlussdose 2 und dem Erweiterungsmodul 3 ist ein zweites Erweiterungsmodul 20 eingesetzt, welches eine elektronische Schaltung zur Steuerung und/oder Regelung der Funktionsweise eines angeschlossenen Solarpanels umfasst. Das zweite Erweiterungsmodul 20 dient zur flexiblen Erweiterung der Funktion der Solardose 1. Das zweite Erweiterungsmodul ist über normierte Schnittstellen 4 mit der Anschlussdose 2 und dem ersten Erweiterungsmodul 3 wirkverbunden und wirkt - falls vorhanden - mit in diesen integrierten elektronischen Bauelementen zusammen. Ansonsten dient das zweite Erweiterungsmodul zur Übertragung von Strom vom der Anschlussdose 2 in das erste Erweiterungsmodul 3, an welches die Kabel 12 zur Wirkverbindung mit der Aussenwelt angeschlossen sind.

Wie in **Figur 10** zu erkennen ist, weisen in der gezeigten Ausführungsform sowohl das erste als auch das zweite Erweiterungsmodul 3, 20 einen oder mehrere Füsse 21 auf, welche zum direkten oder indirekten Abstützen auf der Oberfläche eines Solarpanels dienen. Bei Bedarf können die Füsse 21 einen oder mehrere Sockel aufweisen, welche zur Befestigen an einer Oberfläche eines Solarpanels geeignet sind. Die Füsse 21 bewirken, dass die Rückwand des ersten und des zweiten Erweiterungsmoduls 3, 20 in einem gewissen Abstand vom Solarpanel angeordnet sind, was zur einer Verbesserung der Kühlung beiträgt. Falls bei einem Erweiterungsmodul keine oder nur geringe Kühlung erforderlich ist, kann dieses auch so ausgestaltet sein, dass es direkt auf der Oberfläche eines Solarpanels aufliegt. Weiterhin weist die Anschlussdose 2 ein erstes Kupplungsteil 22 auf, welches mit einem zweiten Kupplungsteil 23 einer Halteschiene 24 wirkverbindbar ist. Die Halteschiene 24 ist als separates Teil ausgebildet und kann ebenfalls flexibel und bei Bedarf nachgerüstet werden. Die Halteschiene 24 ist so ausgestaltet, dass sie auf der Oberfläche eines Solarpanels z.B. durch Festkleben befestigt werden kann. Bei Bedarf kann die Halteschiene 24 fest mit dem zweiten Erweiterungsmodul 20 wirkverbunden sein. Die Halteschiene 24 dient u.a. zur präzisen Positionierung der Erweiterungsmodule 3, 20 gegenüber der Anschlussdose 2.

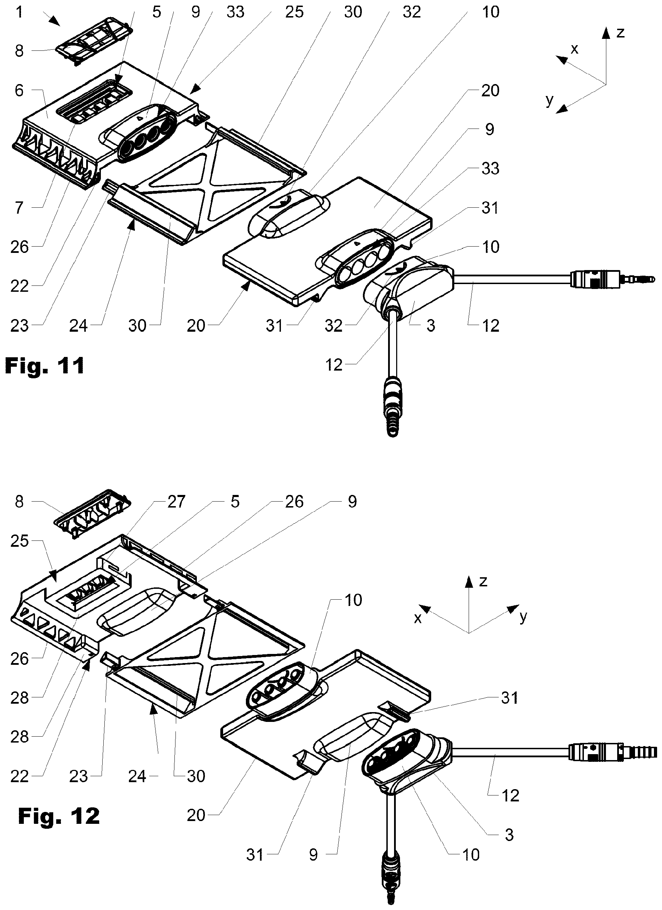

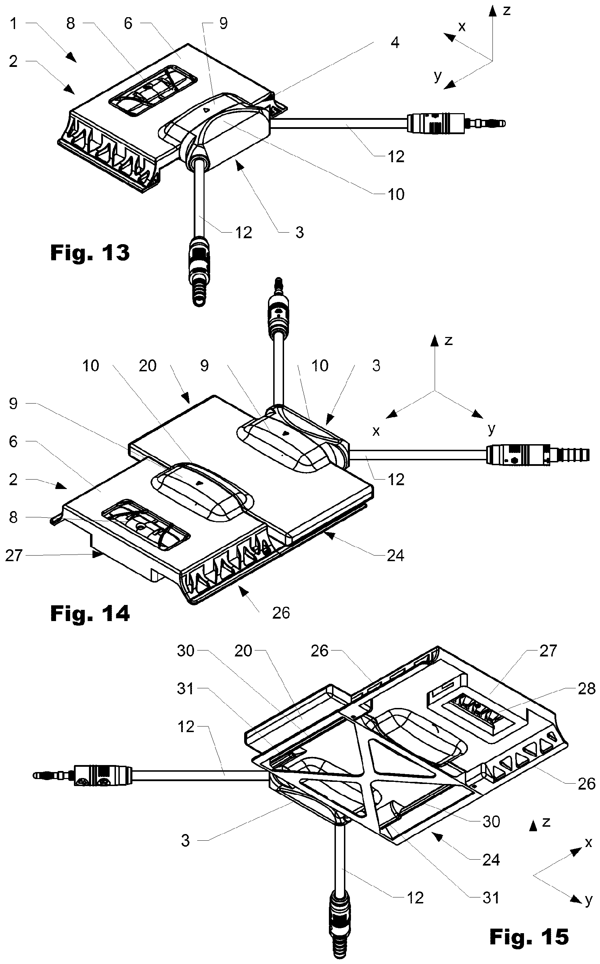

In den **Figuren 11** bis **15** ist eine dritte Ausführungsform einer Solardose 1 dargestellt. Diese besteht wiederum aus einer Anschlussdose 2, sowie einem ersten und einem zweiten Erweiterungsmodul 3, 20. In den **Figuren 11** und **12** ist die Solardose in demontiertem Zustand dargestellt, so dass der Aufbau besser ersichtlich ist. In den **Figuren 13** bis **15** sind die einzelnen Module in wirkverbundenem Zustand dargestellt.

Die Anschlussdose 2 weist wiederum einen Anschlussschacht 5 auf, der durch ein Gehäuse 6 der Anschlussdose 2 gebildet wird. Im Anschlussschacht 5 sind Kontakte 7 angeordnet, welche mit einem ersten Verbinderteil 9 in Wirkverbindung stehen. Der Anschlussschacht 5 kann durch einen Deckel 8 verschlossen werden.

Die Kontakte 7 sind im Wesentlichen auf der Höhe des ersten Verbinderteils 9 angeordnet. Dies weist den Vorteil auf, dass das Innenleben der Anschlussdose 2 einfach gestaltet werden kann. Die Anschlussdose 2 weist in der gezeigten Ausführungsform einen mehrteiligen Sockel 25 auf, der zwei hier seitlich angeordnete und entlang einer Längskante verlaufende Abstützungen 26 umfasst. Weiterhin weist der Sockel 25 einen den Anschlussschacht 5 umgebenden zweiten Bereich 27 auf. Durch den Sockel 25 wird die Rückwand der Anschlussdose 2 vom der Oberfläche eines Solarpanels abgehoben, was zu einer verbesserten Kühlung beiträgt. Sowohl der erste als auch der zweite Teil 26, 27 des Sockels 25 weisen Flächen 28 auf, welche zur Aufnahme von Klebstoff oder doppelseitigem Klebband dienen. Der Sockel 25 bewirkt ein Abheben / Beabstanden einer Rückwand 29 der Anschlussdose 2 gegenüber einem Solarpanel und verbessert dadurch die Kühlung. Die Abstützung 26 weist konkave erste Kupplungsteile 22 in Form von Öffnungen auf, welche zum Einrasten von hier zapfenförmigen zweiten Kupplungsteilen 23 einer Halteschiene 24 dienen. Die Halteschiene 24 weist auf der Oberseite erste Führungsmittel 30 auf, welche sich zur Aufnahme von zweiten Führungsmittel 31 eignen, die am zweiten Erweiterungsmodul 20 ausgebildet sind. Die Halteschiene 24 kann auch fester Bestandteil eines zweiten Erweiterungsmoduls 3, 20 sein und gemeinsam mit diesem mit der Anschlussdose 2 wirkverbunden werden. Ein Vorteil der dargestellten Ausführungsform besteht darin, dass bei der Montage die Halteschiene 24 mit einer Anschlussdose 2 zusammengesteckt und anschliessend auf einer Oberfläche eines Solarpanels befestigt werden kann. Anschliessend kann ein Erweiterungsmodul 20 in die Schiene in Richtung der Anschlussdose 2 eingeschoben und über die Verbinderteile 9, 10 der normierten Schnittestelle 4 mit dieser wirkverbunden werden. Die mechanische Verriegelung erfolgt über die normierten Schnittstellen oder weitere Wirkverbindungsmittel.

In **Figur 13** ist die Solardose 1 in einer einfachen Konfiguration mit nur einem ersten Erweiterungsmodul 3 wirkverbunden dargestellt. Das erste Erweiterungsmodul 3 weist die Kabel 12 auf, mittels denen die Solardose von aussen her angeschlossen wird. Die Verbinderteile 9, 10 der normierten Schnittelle 4 weisen mechanische Wirkverbindungsmittel 32, 33 auf (vgl. **Figur 11**), welche mit Bezug auf die Verbinderteile 9, 10 unten und oben angeordnet sind.

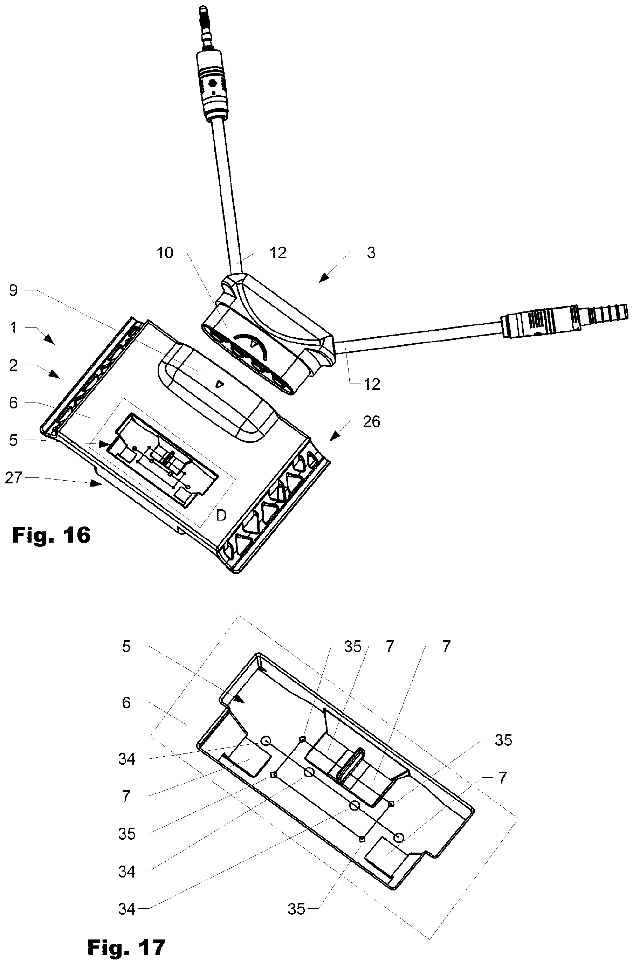

**Figur 16** zeigt eine vierte Ausführungsform einer Solardose 1 in einer perspektivischen Darstellung von schräg vorne und oben. **Figur 17** zeigt Detail D aus Figur 16 in einer vergrösserten Darstellung. Die Solardose 1 entspricht im Wesentlichen der der in Figur 13 gezeigten Ausführungsform, so dass für die allgemeine Beschreibung auf die dazugehörigen Figuren verwiesen wird. Die Solardose 1 besteht in der gezeigten Konfiguration aus einer Anschlussdose 2 und einem ersten Erweiterungsmodul 3. Im Unterschied zu den vorangehenden Ausführungsformen weist die in **Figur 16** gezeigte Variante einen Anschlussschacht 5 mit einer speziellen Anordnung der Kontakte 7 auf, die an unterschiedlichen Schachtwänden 11 ins Schachtinnere vorstehend ausgebildet sind.

Der Anschlussschacht 5 wird durch das Gehäuse 6 der Anschlussdose 2 gebildet. Er verläuft in vertikaler Richtung (z-Richtung), ist hier auf vier Seiten geschlossen und randnah angeordnet. Die Kontakte 7 sind hier aus Blech gebildet und ragen horizontal und bodennah (nahe dem rückseitigen Schachtende) in den Schacht 5 hinein. Die Kontakte sind so angeordnet, dass sie mit unterschiedlich angeordneten Anschlussbändern von unterschiedlichen Solarpaneln kompatibel sind. Zwei unterschiedliche Anordnungen von Anschlussbändern von Solarpaneln werden durch Kreise 34 (vier Kontaktbänder auf einer Linie nebeneinander, 4x1-Anordnung) und Rhomben 35 (rechteckige Anordnung der Kontaktbänder, 2x2-Anordnung) schematisch angedeutet. Die Kontakte 7 sind so angeordnet, dass sie mit den unterschiedlich angeordneten Anschlussbändern 34, 35 kompatibel sind. In der gezeigten Ausführungsform sind die Kontakte 7 an drei Schachtwänden angeordnet. Andere Anordnungen bei denen die gezeigten Position 34, 35 gleichzeitig besetzt werden können sind möglich. Z.B. können die Kontakte 7 unterschiedlich lang ausgebildet sein und von nur einer Schachtwand her auskragen. Alternativ können die Kontakte auf zwei gegenüberliegenden Schachtwänden ausgebildet sein. Weiterhin können die Kontakte auch vertikal stehend ausgebildet sein und falls erforderlich ein oder mehrfach gekrümmt oder geknickt sein. Z.B. können die Kontakte einen L-förmigen Querschnitt aufweisen und vertikal stehend angeordnet sein. Dies ermöglicht die Kontaktierung der Anschlussbänder, ohne dass diese umgebogen werden müssen. Die spezielle Anordnung der Kontakte 7 kann auch in die in den vorangehenden Figuren gezeigten und beschriebenen Ausführungsformen integriert werden.

Ein Vorteil der gezeigten Ausführungsformen liegt darin, dass sie eine sehr geringe Bauhöhe ermöglichen, welche im Bereich von 3 bis 5 cm liegen. Aufgrund des sehr flachen und trotzdem robusten Aufbaus beeinträchtigen die gezeigten Solardosen die Stapelbarkeit der gängigen Solarpanel nicht, da sie innerhalb deren Rahmen montiert werden können.

**Bezugszeichenliste**

| | | | |
|---|---|---|---|
| 1 | Solardose | 20 | zweites Erweiterungsmodul |
| 2 | Anschlussdose | 21 | Fuss |
| 3 | erstes Erweiterungsmodul | 22 | erstes Kupplungsteil |
| 4 | normierte Schnittstelle | 23 | zweites Kupplungsteil |
| 5 | Anschlussschacht / Schacht | 24 | Halteschiene |
| 6 | Gehäuse | 25 | Sockel |
| 7 | Kontakte | 26 | Abstützung (Sockel) |
| 8 | Deckel | 27 | zweiter Bereich (Sockel) |
| 9 | erster Verbinderteil (normierte Schnittstelle) | 28 | Fläche für Klebstoff / Klebeband |
| 10 | zweiter Verbinderteil (normierte Schnittstelle) | 29 | Rückwand |
| 11 | Schachtwand | 30 | erste Führungsmittel |
| 12 | Anschlusskabel | 31 | zweite Führungsmittel |
| 13 | Sockel | 32 | erstes mechanisches Wirkverbindungsmittel |
| 14 | Steg (Sockel) | 33 | zweites mechanisches Wirkverbindungmittel |
| 15 | erstes Wirkverbindungsmittel | 34 | Kreis (4x1 Position Anschlussbänder) |
| 16 | zweites Wirkverbindungsmittel | 35 | Rhombus (2x2 Position Anschlussbänder) |
| 17 | Entriegelungsöffnung | 36 | Trägerelement |
| 18 | Dichtungsnut / Nut | | |
| 19 | Kabelöffnung / Kabelanschluss | | |

## Patentansprüche

1. Solardose (1) mit einer Anschlussdose (2) und mindestens einem Erweiterungsmodul (3, 20), welches mit der Anschlussdose (2) über ein erstes und ein zweites Verbinderteil (9, 10) einer normierten Schnittstelle (4) wirkverbunden werden kann, wobei die Anschlussdose (2) einen Anschlussschacht (5) und Kontakte (7) aufweist, wobei die Kontakte (7) zum Anschliessen an korrespondierende Kontaktbänder eines Solarpanels dienen und von mindestens einer Schachtwand her in den Anschlussschacht (5) hineinmünden, wobei das mindestens eine Erweiterungsmodul (3,20) in montiertem Zustand einem Abstand (a) zum Solarpanel aufweist, so dass ein Spalt resultiert, wobei
die Solardose (1) ein erstes Erweiterungsmodul (3) mit Anschlusskabeln (12) umfasst, und wobei
das erste Erweiterungsmodul (3) elektronische Bauelemente aufweist, welche ein Abkoppeln eines Solarpanels in laufendem Betrieb ermöglichen.

2. Solardose (1) gemäss einem der vorangehenden Patentansprüche, **dadurch gekennzeichnet, dass** die Kontakte (7) so angeordnet sind, dass sie gleichzeitig mit unterschiedlich ausgebildeten Anschlussbändern (34, 35) von unterschiedlichen Solarpaneln kompatibel sind.

3. Solardose (1) gemäss einem der vorangehenden Patentansprüche, **dadurch gekennzeichnet, dass** die Kontakte (7) horizontal und/oder vertikal angeordnet sind.

4. Solardose (1) gemäss einem der vorangehenden Patentansprüche, **dadurch gekennzeichnet, dass** die Kontakte (7) gekrümmt und/oder geknickt sind.

5. Solardose gemäss Patentanspruch 4, **dadurch gekennzeichnet, dass** die Kontakte (7) einen L-förmigen Querschnitt aufweisen.

6. Solardose (1) gemäss einem der vorangehenden Patentansprüche, **dadurch gekennzeichnet, dass** die Anschlussdose (2) mechanische Wirkverbindungsmittel aufweist (15, 32) mittels denen mindestens ein Erweiterungsmodul (3, 20) über zweite Wirkverbindungsmittel (16, 33) mechanisch wirkverbunden werden kann.

7. Solardose (1) gemäss einem der vorangehenden Patentansprüche, **dadurch gekennzeichnet, dass** die Anschlussdose (2) mindestens einen Sockel (25, 26, 27) aufweist, der zur Befestigung der Anschlussdose (2) an einer Oberfläche eines Solarpanels dient.

8. Solardose (1) gemäss einem der vorangehenden Patentansprüche, **dadurch gekennzeichnet, dass** der Sockel (27) den Anschlussschacht (5) umgibt.

9. Solardose (1) gemäss einem der vorangehenden Patentansprüche, **dadurch gekennzeichnet, dass** die Anschlussdose (2) elektronische Bauelemente umfasst.

10. Solardose (1) gemäss einem der vorangehenden Patentansprüche, **dadurch gekennzeichnet, dass** die Anschlussdose (2) mechanische Wirkverbindungsmittel aufweist (22, 23), die zum Anschliessen einer Halteschiene (24) geeignet sind.

11. Solardose (1) gemäss Patentanspruch 10, **dadurch gekennzeichnet, dass** ein Erweiterungsmodul (3) Führungsmittel (31) aufweist, welche mit der Halteschiene (24) wirkverbindbar sind.

12. Anschlussdose (2) zur Verwendung in einer Solardose (1) gemäss einem der vorangehenden Patentansprüche.

13. Erweiterungsmodul (3) zur Verwendung in einer Solardose (1) gemäss einem der vorangehenden Patentansprüche.

## Claims

1. Solar box (1) with a junction box (2) and at least one expansion module (3, 20), which can be operatively connected to the junction box (2) by way of a first and a second connector part (9, 10) of a standardised interface (4), wherein the junction box (2) has a connection duct (5) and contacts (7), wherein the contacts (7) are used for connecting to corresponding connection strips of a solar panel and open into the connection duct (5) from a least one duct wall, wherein when installed the at least one expansion module (3, 20) has a distance (a) from the solar panel, resulting in a gap, wherein
the solar box (1) comprises a first expansion module (3) having connection cables (12) and wherein
the first expansion module (3) has electronic components, which allow a solar panel to be decoupled during operation.

2. Solar box (1) according to any of the preceding claims, **characterised in that** the contacts (7) are disposed so that they are also compatible with differently configured connection strips (34, 35) of different solar panels.

3. Solar box (1) according to any of the preceding claims, **characterised in that** the contacts (7) are disposed horizontally and/or vertically.

4. Solar box (1) according to any of the preceding claims, **characterised in that** the contacts (7) are curved and/or bent.

5. Solar box according to claim 4, **characterised in that** the contacts (7) have an L-shaped cross-section.

6. Solar box (1) according to any of the preceding claims, **characterised in that** the junction box (2) has mechanical operative connecting means (15, 32), by means of which at least one expansion module (3, 20) can be operatively connected mechanically by way of second operative connecting means (16, 33).

7. Solar box (1) according to any of the preceding claims, **characterised in that** the junction box (2) has at least one pedestal (25, 26, 27) which is used to attach the junction box (2) to a surface of a solar panel.

8. Solar box (1) according to any of the preceding claims, **characterised in that** the pedestal (27) surrounds the connection duct (5).

9. Solar box (1) according to any of the preceding claims, **characterised in that** the junction box (2) comprises electronic components.

10. Solar box (1) according to any of the preceding claims, **characterised in that** the junction box (2) has mechanical operative connecting means (22, 23) which are suitable for connecting a retaining rail (24).

11. Solar box (1) according to claim 10, **characterised in that** an expansion module (3) has guide means (31) which are operatively connected to the retaining rail (24).

12. Junction box (2) for use in a solar box (1) according to any of the preceding claims.

13. Expansion module (3) for use in a solar box (1) according to any of the preceding claims.

## Revendications

1. Boîtier pour installations solaires (1) avec un boîtier de connexion (2) et au moins un module d'extension (3, 20), lequel peut coopérer avec le boîtier de connexion (2) par l'intermédiaire d'une première et d'une deuxième partie de liaison (9, 10) d'une interface (4) standardisée, dans lequel le boîtier de connexion (2) présente un port de connexion (5) et des contacts (7), dans lequel les contacts (7) servent à la connexion à des bandes de contact correspondantes d'un panneau solaire et débouchent depuis au moins une paroi de port à l'intérieur du port de connexion (5), dans lequel l'au moins un module d'extension (3, 20) présente, dans l'état monté, une distance (a) par rapport au panneau solaire de sorte qu'il en résulte une fente, dans lequel
le boîtier pour installations solaires (1) comprend un premier module d'extension (3) avec des câbles de connexion (12), et dans lequel
le premier module d'extension (3) présente des composants électroniques, lesquels permettent un découplage d'un panneau solaire lors d'un fonctionnement en cours.

2. Boîtier pour installations solaires (1) selon l'une quelconque des revendications précédentes, **caractérisé en ce que** les contacts (7) sont disposés de telle sorte qu'ils sont compatibles dans le même temps avec des bandes de connexion (34, 35) réalisées de manière différente de différents panneaux solaires.

3. Boîtier pour installations solaires (1) selon l'une quelconque des revendications précédentes, **caractérisé en ce que** les contacts (7) sont disposés de manière horizontale et/ou verticale.

4. Boîtier pour installations solaires (1) selon l'une quelconque des revendications précédentes, **caractérisé en ce que** les contacts (7) sont incurvés et/ou pliés.

5. Boîtier pour installations solaires selon la revendication 4, **caractérisé en ce que** les contacts (7) présentent une section transversale en forme de L.

6. Boîtier pour installations solaires (1) selon l'une quelconque des revendications précédentes, **caractérisé en ce que** le boîtier de connexion (2) présente des moyens de coopération (15, 32) mécaniques, au moyen desquels au moins un module d'extension (3, 20) peut coopérer de manière mécanique par l'intermédiaire de deuxièmes moyens de coopération (16, 33).

7. Boîtier pour installations solaires (1) selon l'une quelconque des revendications précédentes, **caractérisé en ce que** le boîtier de connexion (2) présente au moins un socle (25, 26, 27), qui sert à fixer le boîtier de connexion (2) à une surface d'un panneau solaire.

8. Boîtier pour installations solaires (1) selon l'une quelconque des revendications précédentes, **caractérisé en ce que** le socle (27) entoure le port de connexion (5).

9. Boîtier pour installations solaires (1) selon l'une quelconque des revendications précédentes, **caractérisé en ce que** le port de connexion (2) comprend des composants électroniques.

10. Boîtier pour installations solaires (1) selon l'une quelconque des revendications précédentes, **caractérisé en ce que** le boîtier de connexion (2) présente des moyens de coopération (22, 23) mécaniques, qui sont adaptés pour la connexion d'un rail de maintien (24).

11. Boîtier pour installations solaires (1) selon la revendication 10, **caractérisé en ce qu'**un module d'extension (3) présente des moyens de guidage (31), lesquels peuvent coopérer avec le rail de maintien (24).

12. Boîtier pour installations solaires (2) destiné à être utilisé dans un boîtier pour installations solaires (1) selon l'une quelconque des revendications précédentes.

13. Module d'extension (3) destiné à être utilisé dans un boîtier pour installations solaires (1) selon l'une quelconque des revendications précédentes.
